# EUROPEAN PATENT APPLICATION

(11) **EP 4 319 108 A1**
(43) Date of publication of application: **07.02.2024**
(21) Application number: 22796068.9
(22) Date of filing: 25.04.2022
(51) Int. Cl.: H04M 1/02, H01Q 1/24, H04B 1/44

(54) **RF MEMBER CONNECTED TO ANTENNA, AND ELECTRONIC DEVICE COMPRISING SAME**

(30) Priority: 26.04.2021 KR 20210053822
(71) Applicant: Samsung Electronics Co., Ltd., Suwon-si, Gyeonggi-do 16677 (KR)
(72) Inventor: YOO, Chaeup, Suwon-si, Gyeonggi-do 16677 (KR); SEO, Mincheol, Suwon-si, Gyeonggi-do 16677 (KR); JUNG, Jinwoo, Suwon-si, Gyeonggi-do 16677 (KR); CHO, Huiwon, Suwon-si, Gyeonggi-do 16677 (KR)
(74) Representative: Appleyard Lees IP LLP
(86) International application number: PCT/KR2022/005862
(87) International publication number: WO 2022/231235

(57) **Abstract**

An electronic device according to various embodiments disclosed in the present document may comprise: a display module disposed on the front surface of the electronic device; a frame, which forms the side exterior of the electronic device, includes an inner wall part facing the internal space of the electronic device, and is made of a conductive material; a printed circuit board on which a communication module is disposed, and which is disposed inside the frame; an RF connection member which has at least one portion formed to extend along the inner wall part of the frame, and which is electrically connected to the printed circuit board; a contact hole electrically connected to the RF connection member along the inner wall part of the frame; a screw hole formed in the inner wall part of the frame to form a predetermined angle with respect to the extending direction of the printed circuit board; and a first bolt member coupled to the screw hole through the contact hole. Other various embodiments are possible.

## Description

### [Technical Field]

Various embodiments disclosed in the present document relate to an RF member connected to an antenna and an electronic device comprising the RF member.

### [Background Art]

Because of the design trend of electronic devices, the demand for electronic devices with exterior metal is increasing.

In the case of an electronic device having a first frame of a metal material as an exterior, disposing an antenna inside the first frame may be limited. To overcome this, a method of implementing an antenna and securing radiation performance by utilizing at least a portion of the first frame of the metal material as a radiator of the antenna has been applied.

On the other hand, with the launch of 5G services, additional service bands may be added. Because of this, electronic devices include a larger number of antenna radiators than conventional ones.

### [Disclosure of Invention]

### [Technical Problem]

To use the frame as an antenna in an electronic device having a metal frame as an exterior, the circuit unit and the frame must be electrically connected. The circuit unit may be disposed on the printed circuit board. Therefore, to connect the circuit unit and the frame, the printed circuit board can be extended to the inner side of the frame, and a structure to connect the frame and the printed circuit board can be used.

For high-speed transmission of high-capacity data, technologies such as muti-input and multi-output (MIMO), carrier aggregation (CA), and e-utran new radio dual connectivity (ENDC) are applied, and the number of antennas may be increased to implement this. For example, the number of antennas using a metal material first frame may be increased. The area of the printed circuit board has also been expanded to connect with the increased antenna, but this expansion is also difficult because of the limitation of the internal space of the electronic device.

In addition, the communication signal may be affected by electromagnetic waves generated from electronic components operating in a position adjacent to the wiring through which the communication signal passes.

Various embodiments disclosed in the present document may provide an RF member connected to an antenna that can effectively utilize the internal space of the electronic device and an electronic device comprising the same.

### [Solution to Problem]

An electronic device according to various embodiments disclosed in the present document may comprise: a display module disposed on the front surface of the electronic device; a frame, which forms the side exterior of the electronic device, includes an inner wall part facing the internal space of the electronic device, and is made of a conductive material; a printed circuit board on which a communication module is disposed, and which is disposed inside the frame; an RF connection member which has at least one portion formed to extend along the inner wall part of the frame, and which is electrically connected to the printed circuit board; a contact hole electrically connected to the RF connection member along the inner wall part of the frame; a screw hole formed in the inner wall part of the frame to form a predetermined angle with respect to the extending direction of the printed circuit board; and a first bolt member coupled to the screw hole through the contact hole.

An RF member according to various embodiments disclosed in the present document may include: an RF connection member formed by extending in one direction; at least one groove portion that starts from the first surface of the RF connection member and is formed to be concave to the second surface of the RF connection member opposite to the first surface; and contact holes which are disposed along the one direction and electrically connected to the RF connection member, and at least one of which is disposed in the groove portion.

### [Advantageous Effects of Invention]

According to various embodiments disclosed in the present document, the antenna connection structure can be effectively disposed in a small internal space of the electronic device. The antenna connection structure can be stably fixed inside the electronic device.

In addition, by driving an internal electronic component, noise can be reduced in the communication signal transmitted to the antenna.

### [Brief Description of Drawings]

In connection with the description of the drawings, the same or similar reference numerals may be used for the same or similar components.
FIG. 1 is a block diagram of an electronic device in a network environment according to various embodiments.
FIG. 2a is a perspective view of the front surface of an electronic device according to various embodiments of the present disclosure.
FIG. 2b is a perspective view of the rear surface of an electronic device of FIG. 2a according to various embodiments of the present disclosure.
FIG. 3 is an exploded perspective view of an electronic device of FIG. 2a according to various embodiments of the present disclosure.
FIG. 4 is a perspective view of the RF member according to various embodiments disclosed in the present document.
FIG. 5 is a mimetic diagram of an RF member according to various embodiments disclosed in the present document.
FIG. 6a is a perspective view of the rear surface of an electronic device according to various embodiments disclosed in the present document.
FIG. 6b is an enlarged diagram of area A of FIG. 6a.
FIG. 7 is a cross-sectional view of FIG. 6b taken along B-B.
FIGS. 8a and 8b are drawings illustrating the formation of screw holes in the frame of an electronic device according to various embodiments disclosed in the present document.
FIGS. 9a to 9c are mimetic diagrams of RF members according to various embodiments disclosed in the present document.
FIG. 10 is a diagram illustrating a figure in which the RF member of the embodiment described in FIG. 9c is disposed in an electronic device.

### [Mode for the Invention]

It should be understood that various embodiments of the disclosure and the terms used in the present document are not intended to limit the technological features set forth in the present document to particular embodiments and include various changes, equivalents, or replacements for a corresponding embodiment.

With regard to the description of the drawings, similar reference numerals may be used to refer to similar or related elements. A singular form of a noun corresponding to an item may include one or more of the things, unless the relevant context clearly indicates otherwise.

As used in the present document, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used in the present document, such terms as "1st" and "2nd," or "first" and "second" may be used to simply distinguish a corresponding component from another, and does not limit the components in other aspect (e.g., importance or order). If an element (e.g., a first element) is referred to, with or without the term "operatively" or "communicatively," as "coupled with," "coupled to," "connected with," or "connected to" another element (e.g., a second element), it means that the element may be coupled with the other element directly (e.g., wiredly), wirelessly, or via a third element.

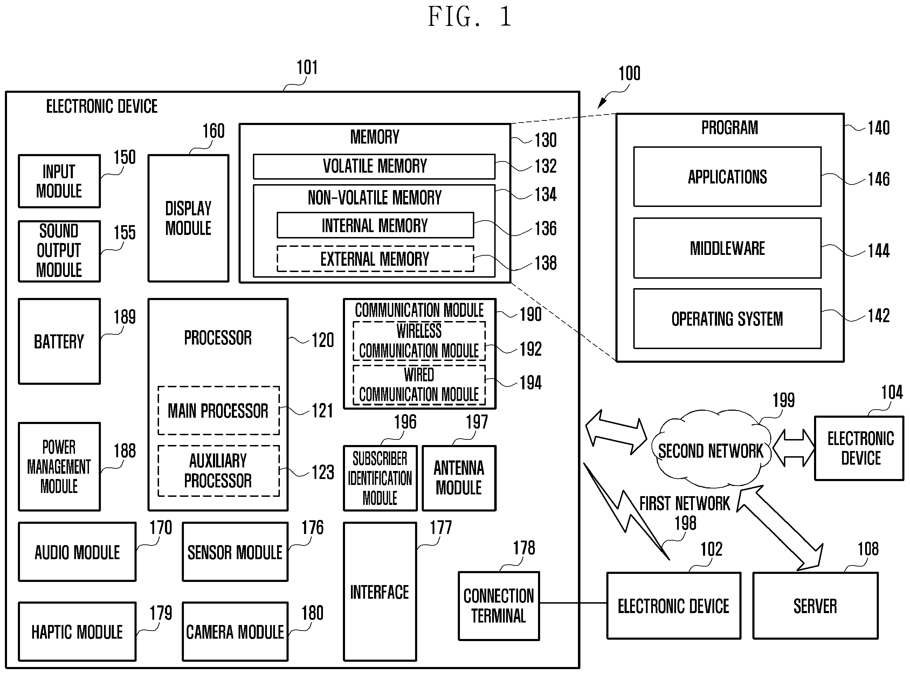

FIG. 1 is a block diagram of an electronic device 101 in a network environment 100 according to an embodiment. With reference to FIG. 1, the electronic device 101 in the network environment 100 may communicate with an external electronic device 102 via a first network 198 (e.g., a short-range wireless communication network), or at least one of an external electronic device 104 or a server 108 via a second network 199 (e.g., a long-range wireless communication network). The electronic device 101 may communicate with the external electronic device 104 via the server 108. The electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, and/or an antenna module 197. In some embodiments of the disclosure, at least one (e.g., the connection terminal 178) of the components may be omitted from the electronic device 101, or one or more other components may be added in the electronic device 101. For example, the sensor module 176, the camera module 180, or the antenna module 197 may be implemented as embedded in single component (e.g., the display module 160)

The processor 120 may execute, for example, software (e.g., a program 140) to control at least one other component (e.g., a hardware or software component) of the electronic device 101 coupled with the processor 120, and may perform various data processing or computation. As at least part of the data processing or computation, the processor 120 may load a command or data received from another component (e.g., the sensor module 176 or the communication module 190) in a volatile memory 132, process the command or the data stored in the volatile memory 132, and store resulting data in a non-volatile memory 134. The processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., a sleep) state, or together with the main processor 121 while the main processor 121 is in an active state (e.g., executing an application). The auxiliary processor 123 (e.g., an ISP or a CP) may be implemented as part of another component (e.g., the camera module 180 or the communication module 190) functionally related to the auxiliary processor 123. According to an embodiment of the disclosure, the auxiliary processor 123 (e.g., a neural network processing device) may include a hardware structure specified for processing an artificial intelligence model. The artificial intelligence model may be created through machine learning. Such learning may be performed, for example, in the electronic device 101 itself on which the artificial intelligence model is performed, or may be performed through a separate server (e.g., the server 108). The learning algorithms may include, for example, supervised learning, unsupervised learning, semi-supervised learning, or reinforcement learning, but is not limited thereto. The artificial intelligence model may include a plurality of artificial neural network layers. The artificial neural network may be any of a deep neural network (DNN), a convolutional neural network (CNN), a recurrent neural network (RNN), a restricted Boltzmann machine (RBM), a deep belief network (DBN), a bidirectional recurrent DNN (BRDNN), a deep Q-network, or a combination of two or more of the above-mentioned networks, but is not limited the above-mentioned examples. In addition to the hardware structure, the artificial intelligence model may additionally or alternatively include a software structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 and/or the non-volatile memory 134.

The program 140 may be stored in the memory 130 as software, and may include, for example, an operating system (OS) 142, middleware 144, and/or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record, and the receiver may be used for incoming calls. The receiver may be implemented as separate from, or as part of the speaker.

The display module 160 may visually provide information to the outside (e.g., a user) of the electronic device 101. The display module 160 may include, for example, a display, a hologram device, or a projector and control circuit to control a corresponding one of the display, hologram device, and projector. The display module 160 may include a touch sensor adapted to detect a touch, or a pressure sensor adapted to measure the intensity of force incurred by the touch.

The audio module 170 may convert a sound into an electrical signal and vice versa. The audio module 170 may obtain the sound via the input module 150, or output the sound via the sound output module 155 or a headphone of an external electronic device (e.g., the external electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. The sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the external electronic device 102) directly (e.g., wiredly) or wirelessly. The interface 177 may include, for example, a high-definition multimedia interface (HDMI), a universal serial bus (USB) interface, a secure digital (SD) card interface, and/or an audio interface.

The connecting terminal 178 may include a connector via which the electronic device 101 may be physically connected with the external electronic device (e.g., the external electronic device 102). The connecting terminal 178 may include, for example, an HDMI connector, a USB connector, an SD card connector, and/or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. The haptic module 179 may include, for example, a motor, a piezoelectric element, or an electric stimulator.

The camera module 180 may capture a still image or moving images. The camera module 180 may include one or more lenses, image sensors, ISPs, or flashes.

The power management module 188 may manage power supplied to or consumed by the electronic device 101. The power management module 188 may be implemented as at least part of, for example, a power management integrated circuit (PMIC).

The battery 189 may supply power to at least one component of the electronic device 101. The battery 189 may include, for example, a primary cell which is not rechargeable, a secondary cell which is rechargeable, and/or a fuel cell.

The communication module 190 may support establishing a direct (e.g., wired) communication channel or a wireless communication channel between the electronic device 101 and the external electronic device (e.g., the external electronic device 102, the external electronic device 104, or the server 108) and performing communication via the established communication channel. The communication module 190 may include one or more CPs that are operable independently from the processor 120 (e.g., the AP) and supports a direct (e.g., wired) communication or a wireless communication. The communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BLUETOOTH, wireless-fidelity (Wi-Fi) direct, or IR data association (IrDA)) or the second network 199 (e.g., a long-range communication network, such as a legacy cellular network, a 5th generation (5G) network, a next generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network, after a 4th generation (4G) network, and next-generation communication technology, e.g., new radio (NR) access technology. The NR access technology may support high-speed transmission of high-capacity data (i.e., enhanced mobile broadband (eMBB)), minimization of terminal power and connection of multiple terminals (massive machine type communications (mMTC)), or high reliability and low latency (ultra-reliable and low-latency communications (URLLC)). The wireless communication module 192 may support a high-frequency band (e.g., a mmWave band) to achieve, for example, a high data transmission rate. The wireless communication module 192 may support various technologies for securing performance in a high-frequency band, such as beamforming, massive multiple-input and multiple-output (MIMO), full-dimensional MIMO (FD-MIMO), array antenna, analog beam-forming, or large-scale antenna. The wireless communication module 192 may support various requirements specified in the electronic device 101, an external electronic device (e.g., external the electronic device 104), or a network system (e.g., the second network 199). According to an embodiment of the disclosure, the wireless communication module 192 may support a peak data rate for implementing eMBB (e.g., 20Gbps or more), loss coverage for implementing mMTC (e.g., 164dB or less), or U-plane latency for realizing URLLC (e.g., 0.5ms or less for each of downlink (DL) and uplink (UL) or 1ms or less for round trip).

The antenna module 197 may transmit or receive a signal or power to or from the outside (e.g., the external electronic device) of the electronic device 101. The antenna module 197 may include an antenna including a radiating element including a conductive material or a conductive pattern formed in or on a substrate (e.g., a printed circuit board (PCB)). The antenna module 197 may include a plurality of antennas (e.g., an antenna array). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. Another component (e.g., a radio frequency integrated circuit (RFIC)) other than the radiating element may be additionally formed as part of the antenna module 197.

According to various embodiments of the disclosure, the antenna module 197 may form a mmWave antenna module. According to an embodiment of the disclosure, the mmWave antenna module may include a PCB, an RFIC that is disposed on or adjacent to a first surface (e.g., the bottom surface) of the PCB and is capable of supporting a predetermined high-frequency band (e.g., a mmWave band), and a plurality of antennas (e.g., array antennas) that is disposed on or adjacent to a second surface (e.g., the top surface or the side surface) of the PCB and is capable of transmitting or receiving a signal of the predetermined high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

Commands or data may be transmitted or received between the electronic device 101 and the external electronic device 104 via the server 108 coupled with the second network 199. Each of the external electronic devices 102 or 104 may be a device of a same type as, or a different type, from the electronic device 101. All or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide an ultra-low delay service using, for example, distributed computing or MEC. In another embodiment of the disclosure, the external electronic device 104 may include an internet of things (IoT) device. The server 108 may be an intelligent server using machine learning and/or neural networks. According to an embodiment of the disclosure, the external electronic device 104 or the server 108 may be included in the second network 199. The electronic device 101 may be applied to an intelligent service (e.g., smart home, smart city, smart car, or healthcare) based on 5G communication technology or IoT-related technology.

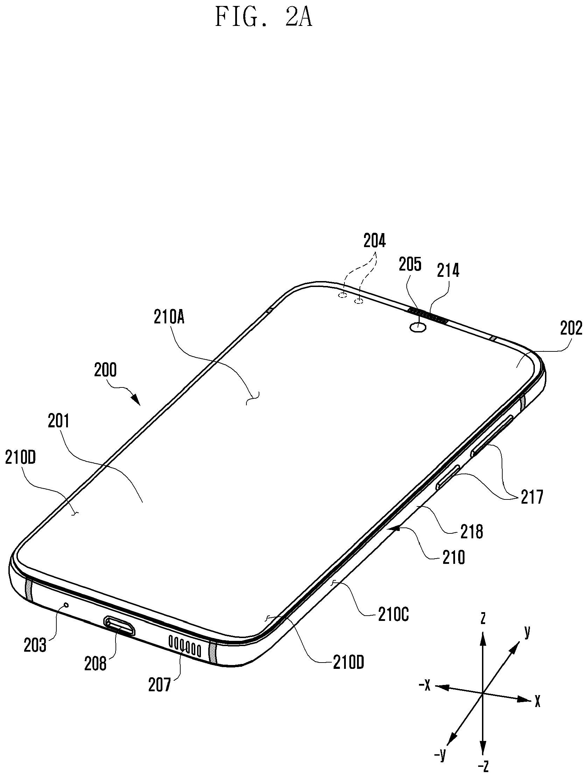

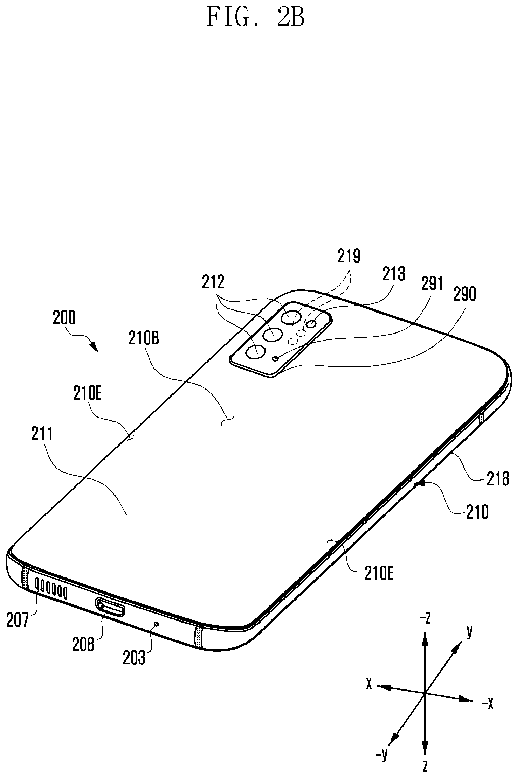

FIG. 2a is a perspective view of the front surface of an electronic device according to various embodiments of the present disclosure. FIG. 2b is a perspective view of the rear surface of the electronic device of FIG. 2a according to various embodiments of the present disclosure.

The electronic device 200 described below may include at least one of the components of the electronic device 101 described in FIG. 1 above.

With reference to FIGS. 2a and 2b, the electronic device 200 according to an embodiment may include a housing 210 including the first surface (or the front surface) 210A, the second surface (or the rear surface) 210B, and the side surface 210C surrounding the space between the first surface 210A and the second surface 210B. In another embodiment (not shown), the housing 210 may refer to a structure forming a portion of the first surface 210A, the second surface 210B, and the side surface 210C of FIG. 2a. According to an embodiment, the first surface 210A may be formed by at least a partially transparent front plate 202 (e.g., a glass plate or a polymer plate comprising various coating layers). The second surface 210B may be formed by a substantially opaque rear plate 211. The rear plate 211 may be formed, for example, by a coated or colored glass, a ceramic, a polymer, a metal (e.g., an aluminum, a stainless steel (STS), or a magnesium), or a combination of at least two of the above materials. The side surface 210C may be coupled with the front plate 202 and the rear plate 211 and may be formed by a side bezel structure 218 (or the "lateral member") including a metal and/or a polymer. In some embodiments, the rear plate 211 and the side bezel structure 218 may be integrally formed and may contain the same material (e.g., a metal material such as an aluminum).

In the illustrated embodiment, the front plate 202 may include a seamlessly extended first area 210D that is curved from the first surface 210a to the rear plate 211 to include both ends of the long edge of the front plate 202. In the illustrated embodiment (e.g., refer to FIG. 2b), the rear plate 211 may include a second area 210E curved from the second surface 210B to the front plate 202 and extended seamlessly. In some embodiments, the front plate 202 or the rear plate 211 may include only one of the first area 210D or the second area 210E. In some embodiments, the front plate 202 may not include the first area and the second area but may include only a flat plane parallel to the second surface 210B. In the embodiments, when viewed from the side of the electronic device, the side bezel structure 218 may have a first thickness (or width) on the side surface that does not include the first area 210D or the second area 210E as described above, and it may have a second thickness thinner than the first thickness on the side surface that includes the first area 210D or the second area 210E.

According to an embodiment, the electronic device 200 may include at least one of a display 201, an input device 203, a sound output device 207 and 214, a sensor module 204 and 219, a camera module 205 and 212, a key input device 217, an indicator (not shown), and a connector 208. In some embodiments, the electronic device 200 may omit at least one of the components (e.g., a key input device 217 or an indicator) or may additionally include other components.

According to an embodiment, the display 201 may be exposed, for example, through a substantial portion of the front plate 202. In some embodiments, at least a portion of the display 201 may be exposed through the first surface 210A and the front plate 202 forming the first area 210D of the side surface 210C. The display 201 may be disposed by being combined with or adjacent to a touch sensing circuit, a pressure sensor capable of measuring the intensity (e.g., the pressure) of the touch, and/or a digitizer detecting a stylus pen of a magnetic field type. In some embodiments, at least a portion of the sensor modules 204 and 219 and/or at least a portion of the key input device 217 may be disposed in the first area 210D and/or the second area 210E.

The input device 203 may include a microphone 203. In some embodiments, the input device 203 may include a plurality of microphones 203 disposed to sense the direction of sound. The sound output devices 207 and 214 may include speakers 207 and 214. The speakers 207 and 214 may include an external speaker 207 and a call receiver 214. In some embodiments, the microphone 203, speakers 207 and 214, and connector 208 may be disposed in the space above the electronic device 200 and may be exposed to the external environment through at least one hole formed in the housing 210. In some embodiments, the holes formed in the housing 210 may be used in common for microphone 203 and speakers 207 and 214. In some embodiments, the sound output devices 207 and 214 may include a speaker (e.g., piezo speaker) operating while excluding the hole formed in the housing 210.

The sensor modules 204 and 219 may generate an electrical signal or data value corresponding to the internal operating state of the electronic device 200 or an external environmental state. The sensor modules 204 and 219 may include, for example, a first sensor module 204 (e.g., a proximity sensor) and/or a second sensor module (not shown) (e.g., a fingerprint sensor) disposed on the first surface 210A of the housing 210, and/or a third sensor module 219 (e.g., an HRM sensor) disposed on the second surface 210B of the housing 210. The fingerprint sensor may be disposed on the first surface 210A (e.g., a home key button) of the housing 210, a partial area of the second surface 210B, and/or below the display 201. The electronic device 200 may further include a sensor module not shown, such as at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illuminance sensor.

The camera module 205 and 212 may include a first camera device 205 disposed on the first surface 210A of the electronic device 200, a second camera device 212 disposed on the second surface 210B, and/or a flash 213. The camera module 205 and 212 may include one or a plurality of lenses, an image sensor, and/or an image signal processor. The flash 213 may include, for example, a light-emitting diode or a xenon lamp. In some embodiments, two or more lenses (e.g., wide-angle, ultra wide-angle and telephoto lenses) and image sensors may be disposed on one side of the electronic device 200.

The key input device 217 may be disposed on the side surface 210C of the housing 210. In another embodiment, the electronic device 200 may not include some or all of the above-mentioned key input devices 217, and the unincluded key input device 217 may be implemented in another form, such as a soft key, on the display 201. In another embodiment, the key input device 217 may be implemented using a pressure sensor included in the display 201.

The indicator (not shown) may be disposed, for example, on the first surface 210A of housing 210. The indicator may provide state information of the electronic device 200, for example, in optical form (e.g., an light-emitting element). In another embodiment, the light-emitting element may provide a light source that is interworked, for example, with the operation of the camera module 205. The indicator may include, for example, an LED, an IR LED, and a xenon lamp.

The connector hole 208 may include a first connector hole accommodating a connector (e.g., a universal serial bus (USB) connector) for transmitting and receiving power and/or data to/from an external electronic device and/or a second connector hole (or earphone jack) (not shown) accommodating a connector transmitting and receiving an audio signal to/from the external electronic device.

Some camera modules 205 of the camera modules 205 and 212, some sensor modules 204 of the sensor modules 204 and 219, or indicator may be disposed to be exposed through the display 201. For example, the camera module 205, the sensor module 204, or the indicator may be disposed so that it can be in contact with the external environment through an opening perforated to the front plate 202 or the transmission area of the display in the internal space of the electronic device 200. According to an embodiment, the area facing the display 201 and the camera module 205 may be formed as a transmission area having a certain transmittance as part of the area displaying content. According to an embodiment, the transmission area may be formed to have a transmittance in the range of about 5% ~ 20%. This transmission area may include an area that overlaps with an effective area (e.g., field of view area) of the camera module 205 through which light passes for generating an image using an image sensor. For example, the transmission area of the display 201 may include an area with a lower pixel density than the surrounding area. For example, the transmission area may replace the opening. For example, the camera module 205 may include an under display camera (UDC). In another embodiment, some sensor module 204 may be disposed to perform its function in the internal space of the electronic device 200 without being visually exposed through the front plate 202. For example, in this case, the area facing the sensor module 204 of the display 201 may not require a perforated opening.

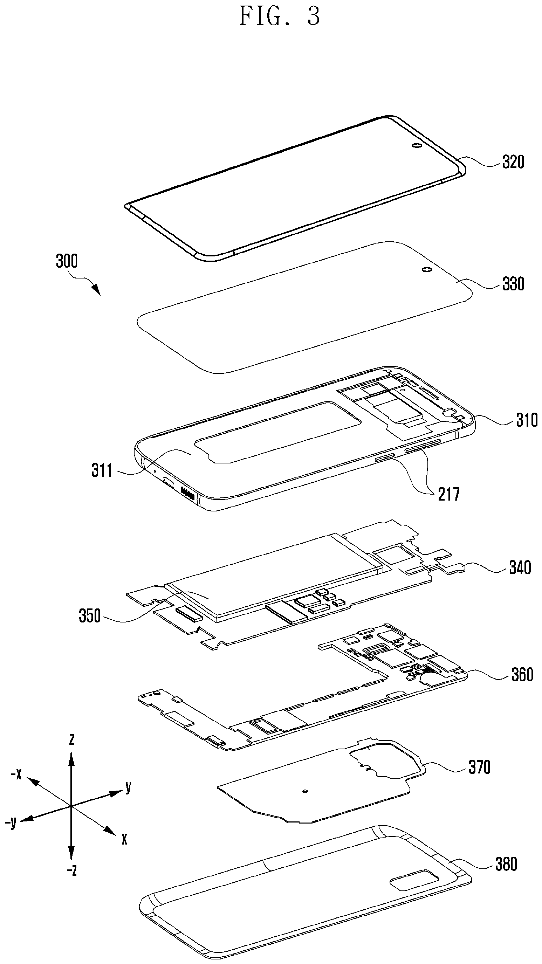

According to various embodiments, the electronic device 200 has an appearance of a bar type or a plate type, but the present disclosure is not limited thereto. For example, the shown electronic device 200 may be a portion of a foldable electronic device, a slidable electronic device, a stretchable electronic device, and/or a rollable electronic device. "Foldable electronic device", "slidable electronic device", "stretchable electronic device" and/or "rollable electronic device" may mean an electronic device capable of being at least partially folded, wounded or rolled, at least partially expanded in area, and/or stored inside the housing (e.g., the housing 210 of FIG. 2a and 2b) as the display (e.g., the display 330 of FIG. 3) has a bending deformation. Foldable electronic devices, slidable electronic devices, stretchable electronic devices, and/or rollable electronic devices may be used by expanding the screen display area by unfolding the display or exposing a larger area of the display to the outside, depending on the user's needs.

FIG. 3 is an exploded perspective view of the electronic device 200 of FIG. 2a according to various embodiments of the present disclosure.

The electronic device 300 of FIG. 3 may be at least partially similar to the electronic device 200 of FIG. 2a and FIG. 2b, or may include other embodiments of the electronic device.

With reference to FIG. 3, the electronic device 300 (e.g., the electronic device 200 of FIG. 2a or FIG. 2b) may comprise: a lateral member 310 (e.g., a side bezel structure), a first support member 311 (e.g., a bracket or a support structure), a front plate 320 (e.g., a front cover), a display 330 (e.g., a display 201 of FIG. 2a), a substrate 340 (e.g., a printed circuit board (PCB), a flexible PCB (FPCB), or a rigid-flexible PCB (RFPCB)), a battery 350, a second support member 360 (e.g., a rear case), an antenna 370, and a rear plate 380 (e.g. , a rear cover). In some embodiments, the electronic device 300 may omit at least one of the components (e.g., the first supporting member 311 or the second supporting member 360) or additionally include other components. At least one of the components of the electronic device 300 may be the same as or similar to at least one of the components of the electronic device 200 of FIG. 2a or FIG. 2b, and the redundant descriptions are omitted below.

The first supporting member 311 may be disposed inside the electronic device 300 and connected to the lateral member 310, or may be integrally formed with the lateral member 310. The first supporting member 311 may be formed, for example, of a metal material and/or a non-metal (e.g., a polymer) material. The first support member 311 may have a display 330 coupled to one surface and a substrate 340 to the other surface. The substrate 340 may be equipped with a processor, a memory, and/or an interface. The processor may include, for example, one or more of a central processing unit, an application processor, a graphics processing unit, an image signal processor, a sensor hub processor, or a communication processor.

The memory, for example, may include a volatile memory or a non-volatile memory.

The interface, for example, may include a high definition multimedia interface (HDMI), a universal serial bus (USB) interface, an SD card interface, and/or an audio interface. The interface, for example, may electrically or physically connect the electronic device 300 to an external electronic device and may include a USB connector, an SD card/MMC connector, or an audio connector.

The battery 350 is a device for supplying power to at least one component of the electronic device 300, including, for example, a non-rechargeable primary battery, a rechargeable secondary battery, or a fuel cell. At least a portion of the battery 350, for example, may be disposed substantially in the same plane as the substrate 340. The battery 350 may be integrally disposed inside the electronic device 300. In another embodiment, the battery 350 may be detachably disposed from the electronic device 300.

The antenna 370 may be disposed between the rear plate 380 and the battery 350. The antenna 370, for example, may include a near field communication (NFC) antenna, a wireless charging antenna, and/or a magnetic secure transmission (MST) antenna. The antenna 370, for example, may wirelessly transmit short-range communication with an external device or wirelessly transmit and receive power required for charging. In another embodiment, an antenna structure may be formed by a portion or combination of the side bezel structure 310 and/or the first support member 311.

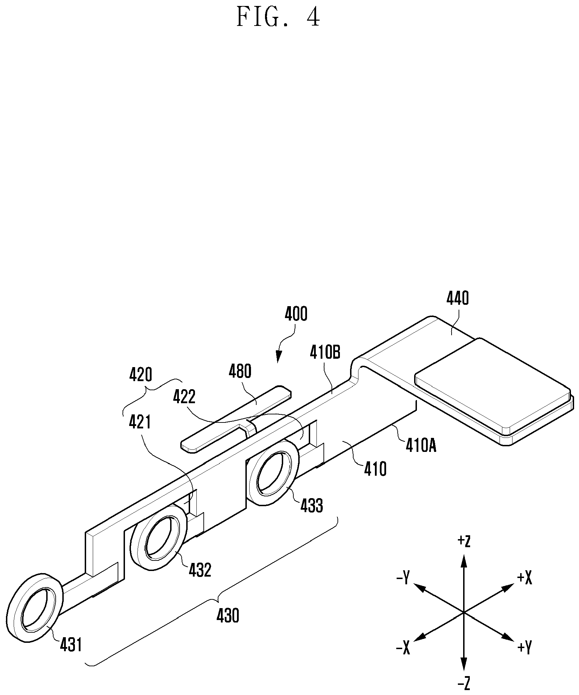

FIG. 4 is a perspective view of the RF member according to various embodiments disclosed in the present document.

The RF member 400 shown in FIG. 4 may be a component for transmitting a radio frequency (RF) signal. For example, the RF member 400 may transmit an RF signal processed in a communication module (e.g., the communication module 180 of FIG. 1) of an electronic device (e.g., the electronic device 101 of FIG. 1, the electronic device 200 of FIG. 2a) to an antenna module (e.g., the antenna module 197 of FIG. 1) or transmit an RF signal received from the antenna module to the communication module.

According to various embodiments, the RF member 400 may include an RF connection member 410, a groove portion 420, a contact hole 430, or a connection portion 440. The components of the RF member 400 described above are only examples, and it may be possible to omit some of the above-described components or add other components to configure the RF member 400.

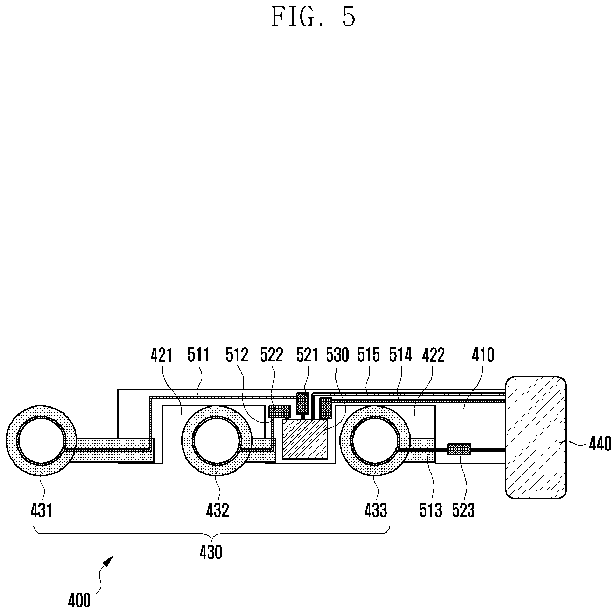

In one embodiment, the RF connection member 410 may include a flexible printed circuit board radio frequency cable (FRC). The RF connection member 410 may be formed of a flexible material and may include a plurality of conductive lines (e.g., signal lines 511, 512, 513, and 514 of FIG. 5). Electrical objects (e.g., the contact holes 430) disposed in the RF connection member 410 may be electrically connected by conductive lines disposed in the RF connection member 410.

In one embodiment, the RF connection member 410 may include a structure in which a plurality of layers are stacked. In some embodiments, a ground VIA may be disposed around the conductive line. Here, the ground VIA may electrically connect the grounds disposed on different layers in a stacking direction in the RF connection member 410 formed by stacking a plurality of layers. For example, a ground disposed on the same layer as the conductive line may be disposed around the conductive line, and a ground disposed on a different layer from the conductive line may be disposed in a position overlapping with the conductive line. Grounds disposed on different layers may be interconnected using VIA. The ground VIA structure may be configured to shield electromagnetic waves generated from other electrical objects to reduce the phenomenon of adding noise to the RF signal transmitted by the conductive line.

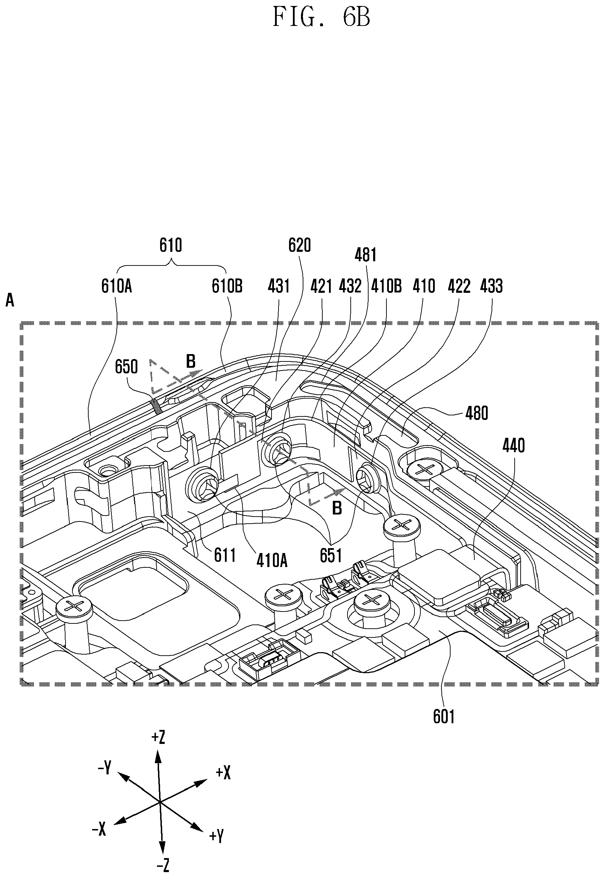

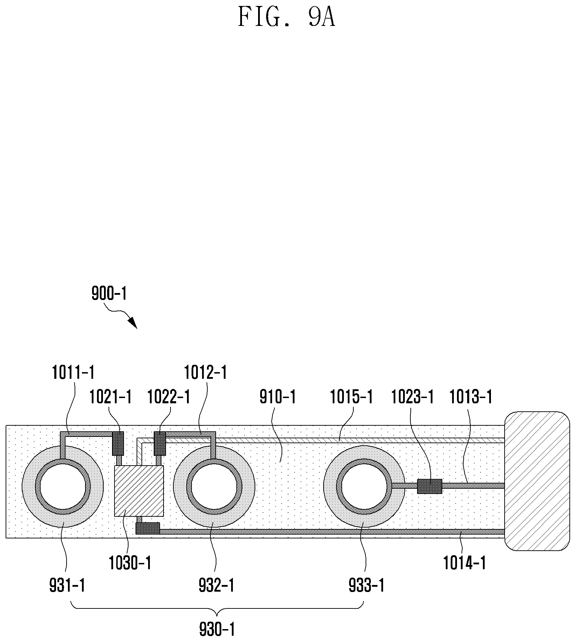

With reference to FIG. 4, the RF connection member 410 may be formed in a shape extending in one direction (e.g., the X-axis direction of FIG. 4). Since the RF connection member 410 is formed of a flexible material, a portion may be bent according to the shape of another component (e.g., the frame 610 of FIG. 6b) facing the RF connection member 410. The shape of the RF connection member 410 shown in FIG. 4 is only an example, and the shape of the RF connection member 410 may be variously changed by design factors such as the shape of the space in which the RF connection member 410 is disposed, and the number of electrical objects. For example, as shown in various embodiments shown in FIGS. 9a to 9c, the RF connection member 410 may vary in shape.

In one embodiment, the groove portion 420 may be an opening formed in a portion of the RF connection member 410. As shown in FIG. 4, the groove portion 420 may be a concave portion starting from the first surface 410A of the RF connection member 410 and formed toward the second surface 410B opposite to the first surface 410A. The RF member 400 may include one groove portion or a plurality of groove portions. For example, the RF member 400 shown in FIG. 4 may include two groove portions 421 and 422. For convenience of explanation, the two groove portions formed in the RF member 400 are described by dividing them into the first groove portion 421 and the second groove portion 422, respectively. In one embodiment, a second contact hole 432 may be disposed in the first groove portion 421, and a third contact hole 433 may be disposed in the second groove portion 422.

According to various embodiments, the contact hole 430 may be electrically connected to the RF connection member 410. For example, the contact hole 430 may be connected to the RF connection member 410 in a soldering manner. The contact hole 430 may be formed of a conductive material. Unlike the RF connection member 410 formed of a flexible material, the contact hole 430 may be formed of a rigid material. For example, the RF connection member 410 may be formed of an alloy including aluminum Al. As shown in FIG. 4, the contact hole 430 may be disposed along a direction in which the RF connection member 410 is extended (e.g., the X-axis direction of FIG. 4). In one embodiment, the RF member 400 may include one contact hole or a plurality of contact holes. In one embodiment, some of the contact holes 430 may be disposed in the groove portion 420.

For example, as shown in FIG. 4, the RF member 400 may include contact holes 431, 432, and 433. The contact hole 430 may include, for example, a first contact hole 431, a second contact hole 432, and/or a third contact hole 433. The first contact hole 431 may be disposed in the outer shell of the RF connection member 410 and electrically connected to the RF connection member 410. The second contact hole 432 may be disposed in the first groove portion 421 and electrically connected to the RF connection member 410. The third contact hole 433 may be disposed in the second groove portion 422 and electrically connected to the RF connection member 410.

According to various embodiments, the connection portion 440 may electrically connect the RF connection member 410 and the printed circuit board of the electronic device (e.g., the printed circuit board 601 of FIG. 6b). In one embodiment, the connection portion 440 may be integrated with the RF connection member 410. In this case, the connection portion 440 may be understood as part of the RF connection member 410. In another embodiment, the connection portion 440 may be formed separately from the RF connection member 410 and electrically connected to the RF connection member 410. With reference to FIG. 4, the connection portion 440 may start at the second surface 410B of the RF connection member 410 and extend in a direction away from the second surface 410B. The connection portion 440 may be partially bended.

In one embodiment, the connection portion 440 may be connected to a printed circuit board of the electronic device by an electrical connection method such as a soldering method, a clip method, a socket method, a bolt method, and/or a bonding method. By electrically connecting the RF member 400 to the printed circuit board of the electronic device, the communication module and the RF member 400 disposed on the printed circuit board may be electrically connected.

According to various embodiments, the RF member 400 may include an additional antenna 480. The additional antenna 480 may be formed of a conductive material and electrically connected to the RF member 400. The additional antenna 480, for example, may transmit or receive RF signals in a high frequency band (e.g., 3.5 GHz to 28 GHz, 28 GHz to 100 GHz (mmWave)).

FIG. 5 is a mimetic diagram of an RF member according to various embodiments disclosed in the present document.

In the following description, the same part number is used for the components same as or similar to those described in FIG. 4, and the detailed description is omitted.

According to various embodiments, conductive lines (e.g., 511, 512, 513, 514, 515) may be disposed on the RF connection member 410. The conductive line may be electrically connected to various electrical objects (e.g., circuit unit, ground, or contact hole 430) disposed on the RF connection member 410. The conductive line may include, for example, a signal line through which an RF signal is transmitted, a power line through which power is transmitted to drive a circuit, and a ground line connected to a ground. The signal line and the ground line may be distinguished according to the components connected thereby. For example, a signal line may mean a line connected to an RF circuit, and a ground line may mean a line connected to various grounds included in an electronic device. With reference to FIG. 5, the RF member 400 may include a plurality of contact holes 430. For example, a conductive line connected to a contact hole connected to the ground can be viewed as a ground line, and a conductive line connected to a contact hole connected to a portion (e.g., the frame of the electronic device (e.g., the frame 610 of FIG. 6b)) transmitting an RF signal can be viewed as a signal line.

In one embodiment, at least one of the plurality of contact holes 430 included in the RF member 400 may be connected to a portion from which the RF signal is radiated, and the other may be connected to the ground. Hereinafter, the first contact hole 431 and the second contact hole 432 are described as being connected to the ground, and the third contact hole 433 is described to be connected to the portion where the RF signal is radiated. In this case, the first conductive line 511, which is a conductive line connected to the first contact hole 431, may be a ground line, and the second conductive line 512, which is a conductive line connected to the second contact hole 432, may also be a ground line. The third conductive line 513, which is a conductive line connected to the third contact hole 433, may be a signal line transmitting an RF signal. However, the RF member 400 of the present disclosure is not limited to the above description.

The conductive line may be extended to the connection portion 440 of the RF member 400. When the connection portion 440 is connected to a printed circuit board of the electronic device (e.g., the printed circuit board 601 of FIG. 6b), a signal line, a ground line, and/or a power line may be connected to the printed circuit board. The RF signal of the communication module (e.g., the communication module 180 of FIG. 1) disposed on the printed circuit board may be transmitted through the signal line, and the power distributed in the power management integrated circuit (PMIC) connected to the printed circuit board 601 may be transmitted through the power line.

According to various embodiments, the RF connection member 410 may include a plurality of circuit units. For example, the RF connection member 410 may include various antenna-related circuits, such as matching circuits (e.g., 521, 522, 523) for impedance matching, and switching circuit 530 for allowing the antenna to correspond to broadband features. For example, a matching circuit may include a device such as an inductor or a capacitor to match impedance. The switching circuit 530 may increase the physical length of the antenna radiators by shorting the antenna radiators that are electrically open to each other. The matching circuit and switching circuit 530 of the circuit unit described above are not limited to their names, but should be understood as circuits including elements capable of performing the corresponding functions. For example, the switching circuit 530 may be referred to as the switching circuit unit 530, and the matching circuit may be referred to as the variable element portion. In one embodiment, some of the matching circuits (e.g., 521, 522, 523), or the switching circuit 530 may be omitted.

With reference to FIG. 5, the first contact hole 431 may be electrically connected to the first conductive line 511. The first conductive line 511 may be electrically connected to the first matching circuit 521 and/or the switching circuit 530. The second contact hole 432 may be electrically connected to the second conductive line 512. The second conductive line 512 may be electrically connected to the second matching circuit 522 and/or the switching circuit 530. The third contact hole 433 may be electrically connected to the third conductive line 513. The third conductive line 513 may be electrically connected to the third matching circuit 523 and electrically connected to the printed circuit board 601 through the connection portion 440. The fourth conductive line 514 may be a conductive line electrically connecting the switching circuit 530 and the printed circuit board 601. The power line 515 may be connected to the printed circuit board 601 as a conductive line that transmits power for driving the switching circuit 530.

For example, the third conductive line 513 may be connected to a communication module of the electronic device (e.g., the communication module 180 of FIG. 1). The RF signal transmitted through the third conductive line 513 may be transmitted to the third contact hole 433 connected to the third conductive line 513. The RF signal may be radiated to a frame connected to the third contact hole 433 (e.g., the frame 601 of FIG. 6b).

In one embodiment, the electrical length of the portion where the RF signal is radiated by the switching circuit 530 included in the RF member 400 may be varied. For example, the electrical length of the antenna may be determined by the position of the portion (feeding point) where the RF signal is fed and the position of the portion (grounding point) where the RF signal exits the antenna. The third contact hole 433 is a portion to transmit an RF signal and may be understood as a feeding point of the antenna. The first contact hole 431 and the second contact hole 432 are components connected to the ground and may be understood as a grounding point of the antenna. The switching circuit 530 may selectively connect at least one of the first contact hole 431 and the second contact hole 432 to the ground. Through this, the position of the grounding point of the antenna can be changed so that the electrical length of the antenna may be varied. The resonant frequency may be changed by changing the electrical length of the antenna.

The connection relationship and disposition of the conductive line and the circuit unit of the RF member 400 described above are only examples, and it may be possible to change the electrical connection relationship of the RF member 400 in various ways within the range that a person skilled in the art can understand.

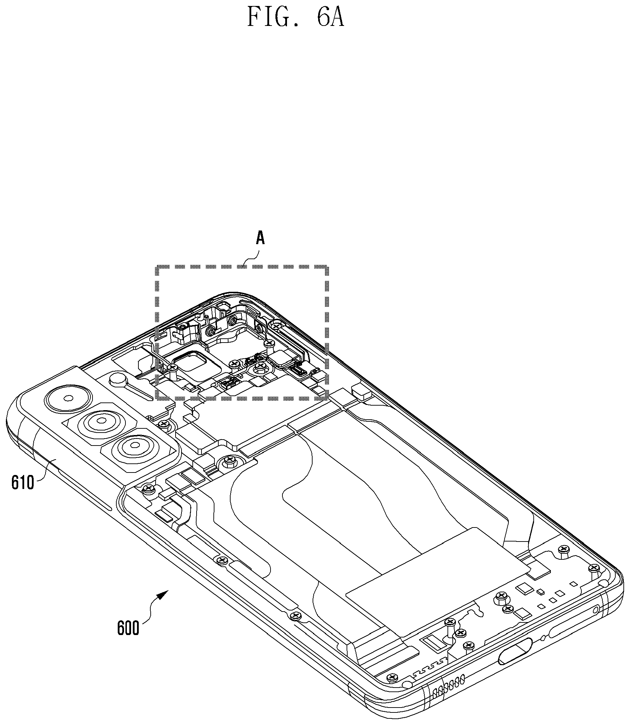

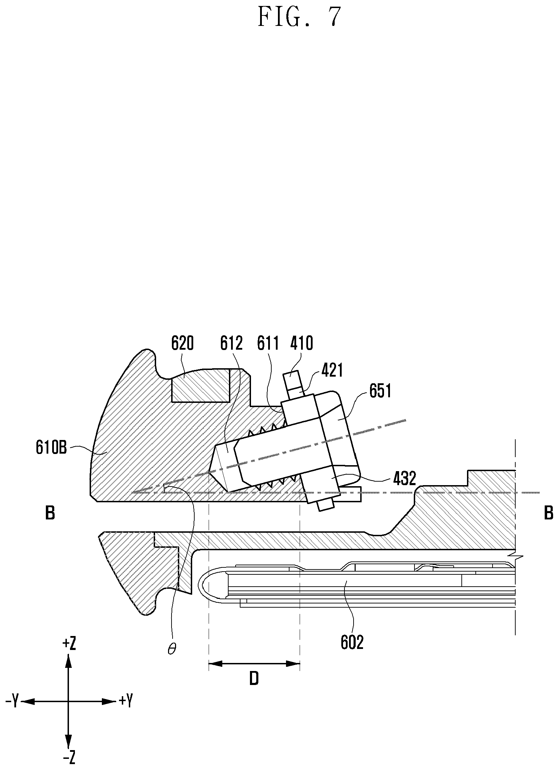

FIG. 6a is a perspective view of the rear surface of an electronic device according to various embodiments disclosed in the present document. FIG. 6b is an enlarged diagram of area A of FIG. 6a. FIG. 7 is a cross-sectional view of FIG. 6b taken along B-B.

The electronic device 600 shown in FIG. 6a may be an example of the electronic device 101 described in FIG. 1 and/or the electronic device 300 described in FIGS. 2a to 3. The drawings of FIGS. 6a and 6b may be drawings in which the rear plate (e.g., the rear plate 380 of FIG. 3) is removed to illustrate the interior of the electronic device 600. Hereinafter, the same part number is used for the components same as or similar to those of the RF member 400 described in FIGS. 4 and 5, and the detailed description is omitted.

With reference to FIGS. 6a and 6b, the housing of the electronic device 600 (e.g., the housing 210 of FIG. 2a) may be formed by frame 610 (e.g., the side bezel structure 218 of FIG. 2a). The frame 610 may form a side exterior of the electronic device 600. For example, the side exterior of the electronic device 600 may mean a surface other than the front surface (e.g., the surface facing the -Z direction of FIG. 6b) and the rear surface (e.g., the surface facing the +Z direction of FIG. 6b) of the electronic device 600. In one embodiment, the frame 610 may include a conductive material. For example, the frame 610 may be formed of an alloy material including aluminum for anodizing treatment. With reference to FIG. 7, the inner side of the frame 610 (e.g., the +Y direction of FIG. 7) may be disposed of an injection-molded component 620 formed by injecting a synthetic resin material. For example, after forming the frame 610, the frame 610 may be inserted into the mold and the injection-molded component 620 may be formed by injecting the molten injection product. The formation methods of the frame 610 and the injection-molded component 620 described above are only examples, and the frame 610 or the injection-molded component 620 may be formed by various process methods such as pressing, CNC, or die casting.

With reference to FIG. 6b, the RF member 400 may be formed to extend along the inner wall part 611 of the frame 610 and may be disposed in close contact with the inner wall part 611 of the frame 610. The inner wall part 611 of the frame 610 may mean a side surface facing the interior of the electronic device 600 in the frame 610. As shown in FIG. 6b, when the RF member 400 is disposed in the corner of the frame 610, the RF member 400 may be partially bended along the shape of the inner wall part 611 of the frame 610.

According to various embodiments, the groove portion 420 of the RF member 400 may start from the surface (e.g., the first surface 410A of FIG. 6b) adjacent to the display module 602 of the electronic device 600 among the surfaces of the RF connection member 410 and be formed to be concave in the direction (e.g., the direction of the second surface 410B of FIG. 6b) away from the display module 602. The display module 602 may be disposed in the front surface (e.g., the first surface (or the front surface) 210A of FIG. 2a) of the electronic device 600. Based on FIG. 7, the display module 602 may be disposed on a surface facing the -Z direction. The electromagnetic waves generated by the operation of the display module 602 may act as noise on the RF signal transmitted through the RF connection member 410. For example, a parasitic resonance generated between the shielding layer and the antenna included in the display module 602 may act as noise on the RF signal. Therefore, as the portion through which the RF signal passes is moved away from the display module 602, the noise may be reduced. Since the groove portion 420 formed on the RF connection member 410 is an opening, the signal line of the RF connection member 410 does not pass through the groove portion 420. As described above, since the groove portion 420 starts from the surface adjacent to the display module 602 and is formed to be concave in the direction away from the display module 602, the display module 602 and the RF connection member 410 may be seen to be separated from the part where the groove portion 420 is formed. As a result, it is possible to reduce the interference phenomenon where the RF signal transmitted through the RF connection member 410 is affected by the operation of the display module 602.

According to various embodiments, the frame 610 may include an electrically separated first frame 610A or a second frame 610B. For example, with reference to FIG. 6b, the first frame 610A and the second frame 610B may be electrically separated by the segmentation portion 650. For example, an insulating material may be disposed in the segmentation portion 650.

In one embodiment, the contact hole 430 of the RF member 400 may be disposed along the inner wall part 611 of the frame 610. For example, the first contact hole 431 may contact the first frame 610A, and the second contact hole 432 and the third contact hole 433 may contact the second frame 610B. When the second contact hole 431 is connected by a switching circuit (e.g., the switching circuit 530 of FIG. 5) included in the RF member 400, a portion of the second frame 610B may function as an antenna radiator. For example, in the portion (feeding point) to which the second frame 610B and the third contact hole 433 are connected, the portion (grounding point) to which the second frame 610B and the second contact hole 431 are connected may function as an antenna radiator.

In some embodiments, the first contact hole 431 and the third contact hole 433 may be connected to a communication module (e.g., the communication module 180 of FIG. 1). In this case, the first contact hole 431 and the third contact hole 433 may be the feeding points of the RF member 400. The RF signal transmitted to the first contact hole 431 may be radiated through the first frame 610A in contact with the first contact hole 431, and the RF signal transmitted to the third contact hole 433 may be radiated through the second frame 610B in contact with the third contact hole 433.

According to various embodiments, a screw hole 612 may be formed in the inner wall part 611 of the frame 610. With reference to FIG. 7, the screw hole 612 may be formed to be tilted at a predetermined angle θ. For example, with respect to the extending direction of the printed circuit board 601 disposed inside the frame 610, the screw hole 612 may be formed to be tilted at a predetermined angle θ. When forming the screw hole 612 at the same depth, if the screw hole 612 is formed in the diagonal direction, the horizontal length D that the screw hole 612 occupy in the frame 610 may be shorter than when forming the screw hole 612 in a horizontal direction (e.g., the Y-axis direction of FIG. 7) or a vertical direction (e.g., the Z-axis direction of FIG. 7). Therefore, there is an advantage of reducing the thickness of the frame 610 (e.g., the length of the Y-axis direction of the frame 610 relative to FIG. 7) compared to forming the screw hole 612 in the horizontal direction.

According to various embodiments, the first bolt member 651 may be bolted to the screw hole 612 through the contact hole 430. The RF member 400 may be fixed to the frame 610 by the first bolt member 651 and be electrically connected to the frame 610. In one embodiment, the RF connection member 410 may include a flexible material, and the contact hole 430 may be formed of a rigid material.

In one embodiment, the number of first bolt members 651 may correspond to the number of contact holes 430. For example, as shown in FIG. 6b, when there are three contact holes (the first contact hole 431, the second contact hole 432, and the third contact hole 433) in the RF member 400, the first bolt members 651 may also be three.

With reference to FIG. 7, the first bolt member 651 may be bolted to the screw hole 612 formed in the frame 610 through the second contact hole 432. The method in which the first bolt member 651 fixes the first contact hole 431 to the frame 610 and/or the method in which the first bolt member 651 fixes the third contact hole 433 to the frame 610 may also be similar to this.

When the first bolt member 651 is coupled to the screw hole 612 formed in the frame 610 through the contact hole 430 respectively, the RF connection member 410 may be stably fixed to the frame 610 without sagging as the RF connection member 410 formed of a flexible material is provided with tension.

According to various embodiments, the connection portion 440 of the RF member 400 may be electrically connected to the printed circuit board 601 of the electronic device 600 disposed inside the frame 610. In order for the connection portion 440 to be spaced apart from the display module 602, the connection portion 440 may extend more adjacent to the rear plate (not shown) disposed on the rear surface (e.g., the surface facing the +Z direction of FIB. 6b) of the electronic device 600 than the display module 602 and may be electrically connected to the printed circuit board 601.

According to various embodiments, an additional antenna 480 of the RF member 400 may be disposed at least one of the frame 610 and the injection-molded component 620. The additional antenna 480 may be seated in the groove 481 formed in the frame 610 or the injection-molded component 620. FIG. 6b describes that the groove 481 in which the additional antenna 480 is seated is formed in the injection-molded component 620, but depending on the placement position of the additional antenna 480, the groove 481 may be located in the frame 610 and may be located in both the injection-molded component 620 and the frame 610. In one embodiment, when the additional antenna 480 is located in the frame 610, the additional antenna 480 and the frame 610 may be positioned so that they can be electrically separated. For example, an insulating member may be disposed between the additional antenna 480 and the frame 610.

For example, the portion in which the additional antenna 480 shown in FIG. 6b is disposed may be a portion covered by the rear plate of the electronic device 600 removed for illustration. Thus, an additional antenna 480 may be disposed between the frame 610 and the rear plate. In one embodiment, the rear plate facing the additional antenna 480 may be formed of a material other than a metal material so that the additional antenna 480 can effectively transmit or receive an RF signal in the high frequency band.

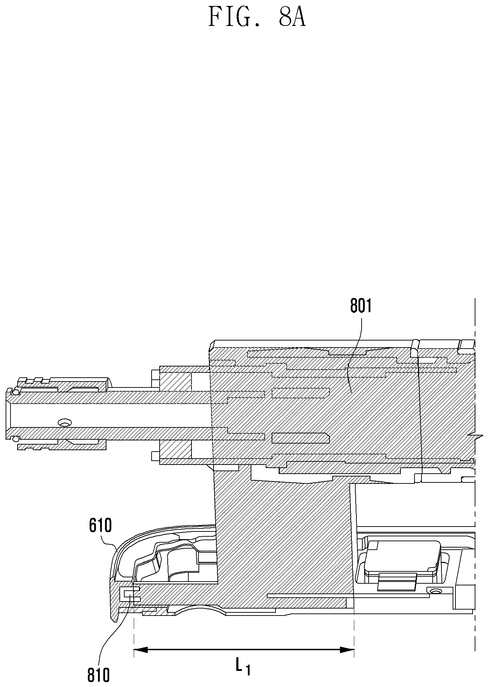

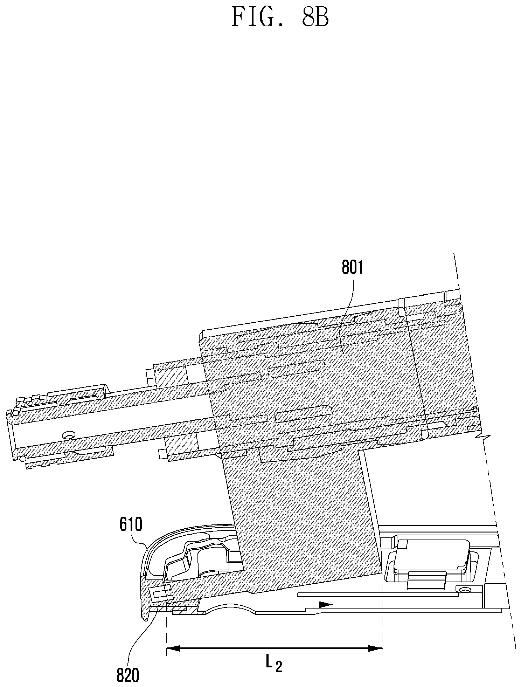

FIGS. 8a and 8b are drawings illustrating the formation of screw holes in the frame of an electronic device according to various embodiments disclosed in the present document.

FIG. 8a is a diagram illustrating the formation of a screw hole 810 in a horizontal direction on the frame 610, and FIG. 8b is a diagram illustrating the formation of a screw hole 820 in a diagonal direction on the frame 610.

In FIG. 8a, the length at which the processing component 801 forming the screw hole 810 is inserted inside the electronic device 600 to form the screw hole 810 may be equal to L1. It may be understood that at least as much free space as L1 is required for processing the screw hole 810.

In FIG. 8b, the length at which the processing component 801 forming the screw hole 820 is inserted inside the electronic device 600 to form the screw hole 820 may be equal to L2. It may be understood that at least as much free space as L2 is required for processing the screw hole 820.

When the same processing component 801 is used, the length of L2 is shorter than the length of L1. It can be seen that in the case of diagonally forming the screw hole, the free space required for screw hole processing is less than in the case of horizontally forming the screw hole. Therefore, it can be seen that the processing difficulty is lower when the screw hole is formed diagonally on the frame 610 (in the case of FIG. 8b) than when the screw hole is formed horizontally (in the case of FIG. 8a).

FIGS. 9a to 9c are mimetic diagrams of RF members according to various embodiments disclosed in the present document. Hereinafter, in describing various embodiments of RF members, the detailed explanations of the components same as or similar to those described in FIGS. 4 and 5 will be omitted and the differences will be explained.

First, one embodiment of an RF member is described with reference to FIG. 9a. In this embodiment, the RF member 900-1 may not include a groove portion (e.g., the groove portion 420 of FIG. 4). The first contact hole 931-1, the second contact hole 932-1, and the third contact hole 933-1 of the RF member 900-1 may be formed in a shape that fits the opening formed in the RF connection member 910-1 and be inserted into the opening formed in the RF connection member 910-1. The first conductive line 1011-1 may be connected to the first contact hole 931-1 and connected to the first matching circuit 1021-1 and the switching circuit 1030-1. The second conductive line 1012-1 may be connected to the second contact hole 932-1 and connected to the second matching circuit 1022-1 and the switching circuit 1030-1. The third conductive line 1013-1 may be connected to the third contact hole 933-1 and connected to the third matching circuit 1023-1. The fourth conductive line 1014-1 may electrically connect a printed circuit board of an electronic device (e.g., the printed circuit board 601 of FIG. 6b) and the switching circuit 1030-1. The power line 1015-1 may be a conductive line supplying power for driving the switching circuit 1030-1.

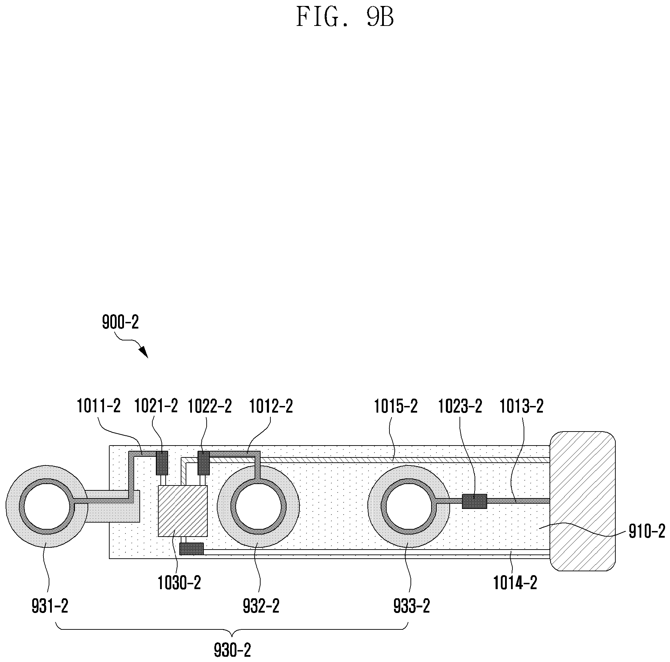

Next, another embodiment of the RF member will be described with reference to FIG. 9b. In this embodiment, the RF member 900-2 may not include a groove portion (e.g., the groove portion 420 of FIG. 4), which is similar to the embodiment described in FIG. 9a above. The first contact hole 931-2 of the RF member 900-2 may be disposed in the outer shell of the RF connection member 910-2 and connected to the RF connection member 910-2. Similar to the embodiments described in FIG. 9a, the second contact hole 932-2 and the third contact hole 933-3 may be formed to fit the opening formed in the RF connection member 910-2 and be inserted into the opening. The first conductive line 1011-2 may be connected to the first contact hole 931-2 and connected to the first matching circuit 1021-2 and the switching circuit 1030-2. The second conductive line 1012-2 may be connected to the second contact hole 932-2 and connected to the second matching circuit 1022-2 and the switching circuit 1030-2. The third conductive line 1013-2 may be connected to the third contact hole 933-2 and connected to the third matching circuit 1023-2. The fourth conductive line 1014-2 may electrically connect a printed circuit board of an electronic device (e.g., the printed circuit board 601 of FIG. 6b) and the switching circuit 1030-2. The power line 1015-2 may be a conductive line supplying power for driving the switching circuit 1030-2.

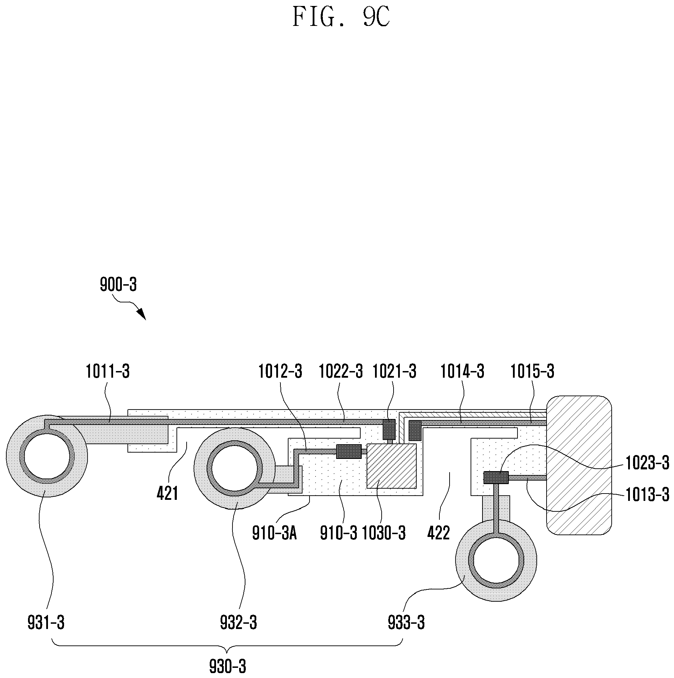

Next, another embodiment of the RF member will be described with reference to FIG. 9c. In this embodiment, the RF member 900-3 may include a groove portion 420, which is similar to the embodiments described in FIGS. 4 and 5 above. The first contact hole 931-3 of the RF member 900-3 may be disposed in the outer shell of the RF connection member 910-3 and connected to the RF connection member 910-3. The second contact hole 932-3 may be disposed in the first groove portion 421. The third contact hole 933-3 may be disposed in the outer shell of the RF connection member 910-3 and connected to the RF connection member 910-3. The third contact hole 933-3 may be disposed at a position adjacent to the first surface 910-3A of the RF connection member 910-3. The first conductive line 1011-3 may be connected to the first contact hole 931-3 and connected to the first matching circuit 1021-3 and the switching circuit 1030-3. The second conductive line 1012-3 may be connected to the second contact hole 932-3 and connected to the second matching circuit 1022-3 and the switching circuit 1030-3. The third conductive line 1013-3 may be connected to the third contact hole 933-3 and connected to the third matching circuit 1023-3. The fourth conductive line 1014-3 may electrically connect a printed circuit board of an electronic device (e.g., the printed circuit board 601 of FIG. 6b) and the switching circuit 1030-3. The power line 1015-3 may be a conductive line supplying power for driving the switching circuit 1030-3. In one embodiment, the third contact hole 933-3 may be electrically connected to a support member (e.g., the first support member 311 of FIG. 3 (e.g., a bracket or a support structure)). For example, the third contact hole 933-3 may be fixed to the other surface substantially perpendicular to one surface in which the first contact hole 931-3 or the second contact hole 932-3 is fixed.

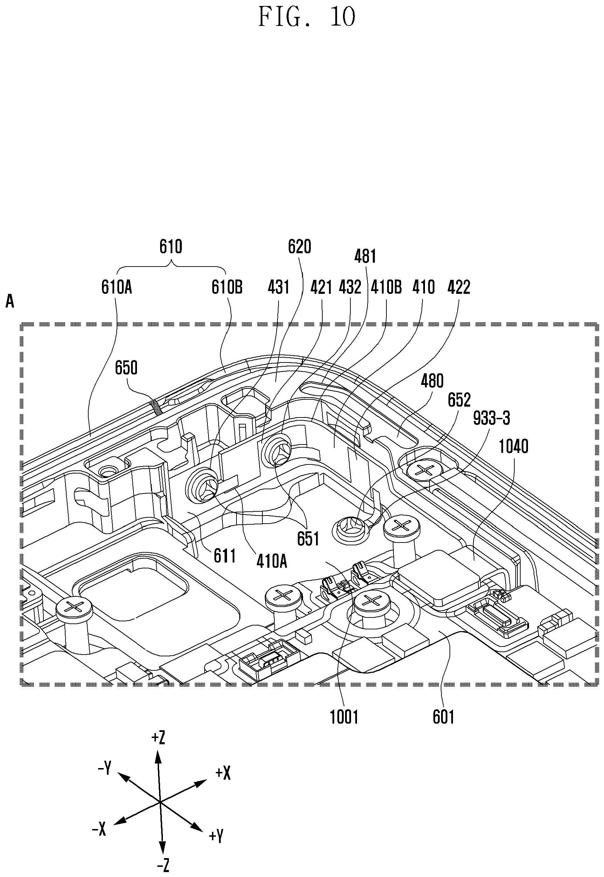

FIG. 10 is a diagram illustrating a figure in which the RF member of the embodiment described in FIG. 9c is disposed in an electronic device.

In describing FIG. 10, the same part number is used for the components same as or similar to those described in FIGS. 6a to 7 and 9c, and the detailed description is omitted.

In this embodiment, the first contact hole 931-3 of the RF member (e.g., the RF member 900-3 of FIG. 9c) is disposed so that it is in contact with the first frame 610A, and, by coupling the first bolt member 651 to the first frame 610A through the first contact hole 931-3, the first contact hole 931-3 may be fixed in a state where it contacts the first frame 610A. The second contact hole 932-3 is disposed so that it is in contact with the second frame 610B, and, by coupling the first bolt member 651 to the second frame 610B through the second contact hole 932-3, the second contact hole 932-3 may be fixed in a state where it contacts the second frame 610B.

In this embodiment, the third contact hole 933-3 of the RF member may be disposed to be in contact with a metal plate 1001 (e.g., the first support member 311 of FIG. 3) (e.g., a bracket or support structure) of a conductive material disposed on the front surface (e.g., the surface facing the -Z direction of FIG. 10) of the electronic device. The third contact hole 933-3 may be fixed to the metal plate 1001 by a second bolt member 652. The second bolt member 652 may be bolted to the metal plate 1001 through the third contact hole 933-3. The third contact hole 933-3 may be electrically connected to the metal plate 1001. The metal plate 1001 may be a ground in the electronic device. For example, the metal plate 1001 may be electrically connected to the grounding portion (not shown) of the printed circuit board 601 and function as a ground. By the metal plate 1001 and the third contact hole 933-3 being contacted, the third contact hole 933-3 may also be connected to the ground.

An electronic device (e.g., the electronic device 101 of FIG. 1, the electronic device 200 of FIG. 2a, and the electronic device 600 of FIG. 6a) according to various embodiments disclosed in the present document may comprise: a display module (e.g., the display 330 of FIG. 3) disposed on the front side of the electronic device; a frame (e.g., the frame 610 of FIG. 6b), which forms the side exterior of the electronic device, includes an inner wall part (e.g., the inner wall part 611 of FIG. 6b) facing the internal space of the electronic device, and is made of a conductive material; a printed circuit board (e.g., the printed circuit board 601 of FIG. 6b) on which a communication module (e.g., communication module 180 in FIG. 1) is disposed, and which is disposed inside the frame; an RF connection member (e.g., the RF connection member 410 of FIG. 4) which has at least one portion formed to extend along the inner wall part of the frame, and which is electrically connected to the printed circuit board; a contact hole (e.g., the contact hole 430 of FIG. 4) electrically connected to the RF connection member along the inner wall part of the frame; a screw hole (e.g., the screw hole 612 of FIG. 7) formed in the inner wall part of the frame to form a predetermined angle with respect to the extending direction of the printed circuit board; and a first bolt member (e.g., the first bolt member 651 of FIG. 7) coupled to the screw hole through the contact hole.

In addition, the RF connection member may include at least one groove portion (e.g., the groove portion 420 of FIG. 4) that starts from a surface adjacent to the display module and is formed to be concave in a direction away from the display module.

In addition, the contact hole may be formed of a material different from the RF connection member and may be disposed in at least one groove portion and connected to the RF connection member.

In addition, the RF connection member may be formed of a flexible material, and the contact hole may be formed of a rigid material.

In addition, the connection portion (e.g., the connection portion 440 of FIG. 4) may be further included, one end of which is connected to the RF connection member and extends adjacent to the rear plate (e.g., the rear plate 380 of FIG. 3) disposed on the rear surface of the electronic device, and the other end of which is connected to the printed circuit board and the RF connection member is connected to the printed circuit board.

In addition, the frame may include a first frame (e.g., the first frame 610A of FIG. 6b) and a second frame (e.g., the second frame 610B of FIG. 6b) which are electrically separated, and the contact hole may include may include a first contact hole (e.g., the first contact hole 431 of FIG. 4) in contact with the first frame and a second contact hole (e.g., the second contact hole 432 of FIG. 4) in contact with the second frame.

In addition, a switching circuit (e.g., the switching circuit 530 of FIG. 5) selectively connected to at least one of the first contact hole and the second contact hole of the printed circuit board and disposed on the RF connection member may be further included.

In addition, a metal plate (e.g., the metal plate 1001 of FIG. 10) of a conductive material disposed in the frame, a third contact hole (e.g., the third contact hole 933-3 of FIG. 10) connected to the RF connection member and being in contact with the metal plate, and a second bolt member (e.g., the second bolt member 652 of FIG. 10) coupled to the metal plate through the third contact hole may be further included.

In addition, an additional antenna (e.g., an additional antenna 480 of FIG. 4) connected to the RF connection member and disposed in the frame and formed of a conductive material may be further included.

In addition, the groove portion may include a first groove portion (e.g., the first groove portion 421 of FIG. 4) and a second groove portion (e.g., the second groove portion 422 of FIG. 4) formed at different locations, and the contact hole may include a first contact hole (e.g., the first contact hole 431 of FIG. 4), a second contact hole (e.g., the second contact hole 432 of FIG. 4) disposed in the first groove portion, and a third contact hole (e.g., the third contact hole 433 of FIG. 4) disposed in the second groove portion.

An RF member (e.g., the RF member 400 of FIG. 4) according to various embodiments disclosed in the present document may comprise: an RF connection member (e.g., the RF connection member 410 of FIG. 4) formed by extending in one direction; at least one groove portion (e.g., the groove portion 420 of FIG. 4) that starts from the first surface of the RF connection member and is formed to be concave to the second surface of the RF connection member opposite to the first surface; and contact holes (e.g., the contact hole 430 of FIG. 4) that are disposed along the one direction and electrically connected to the RF connection member, and at least one of which is disposed in the groove portion.

In addition, the RF connection member and the contact hole may be formed of different materials.

In addition, the RF connection member may be formed of a flexible material, and the contact hole may be formed of a rigid material.

In addition, a connection portion connected to a portion adjacent to the first surface of the RF connection member and extending in a direction away from the second surface of the RF connection member (e.g., the connection portion 440 of FIG. 4) may be further included.

In addition, the contact hole may include a first contact hole (e.g., the first contact hole 431 of FIG. 4) and a second contact hole (e.g., the second contact hole 432 of FIG. 4), each of which contacts separate conductive members electrically separated from each other.

In addition, a switching circuit (e.g., the switching circuit 530 of FIG. 5) selectively connecting at least one of the first contact hole and the second contact hole and disposed on the RF connection member may be further included.

In addition, an additional antenna (e.g., the additional antenna 480 of FIG. 4) connected to the RF connection member and formed of a conductive material may be further included.

In addition, the groove portion may include a first groove portion (e.g., the first groove portion 421 of FIG. 4) and a second groove portion (e.g., the second groove portion 422 of FIG. 4) formed at different locations, and the contact hole may include a first contact hole (e.g., the first contact hole 431 of FIG. 4), a second contact hole (e.g., the second contact hole 432 of FIG. 4) disposed in the first groove portion, and a third contact hole (e.g., the third contact hole 433 of FIG. 4) disposed in the second groove portion.

In addition, a first bolt member (e.g., the first bolt member 651 of FIG. 7) that is coupled to a screw hole (e.g., the screw hole 612 of FIG. 7) formed in the inner wall part (e.g., the inner wall part 611 of FIG. 6b) of the frame (e.g., the frame 610 of FIG. 6b) of the electronic device (e.g., the electronic device 101 of FIG. 1, the electronic device 200 of FIG. 2a, and the electronic device 600 of FIG. 6a) through the contact hole may be installed in the electronic device.

In addition, the screw hole of the electronic device may be formed on the inner wall part of the frame to form a predetermined angle with respect to the extending direction of the printed circuit board of the electronic device.

In addition, the embodiments of the present document disclosed in the present specification and drawings are merely presented as specific examples to easily explain the technical contents according to the embodiments disclosed in the present document and to facilitate the understanding of the embodiments disclosed in the present document, but are not intended to limit the scope of the embodiments disclosed in the present document. Therefore, the scope of the various embodiments disclosed in the present document should be interpreted to include all changes or modifications derived based on the technical ideas of the various embodiments disclosed in the present document, in addition to the embodiments disclosed in the present document.

## Claims

1. An electronic device comprising:
a display module disposed on the front of the electronic device;
a frame, which forms the side exterior of the electronic device, comprises an inner wall part facing the internal space of the electronic device, and is made of a conductive material;
a printed circuit board on which a communication module is disposed, and which is disposed inside the frame;
an RF connection member which has at least one portion formed to extend along the inner wall part of the frame, and which is electrically connected to the printed circuit board;
a contact hole electrically connected to the RF connection member along the inner wall part of the frame;
a screw hole formed in the inner wall part of the frame to form a predetermined angle with respect to the extending direction of the printed circuit board; and
a first bolt member coupled to the screw hole through the contact hole.

2. The electronic device of claim 1, wherein the RF connection member comprises at least one groove portion that starts from a surface adjacent to the display module and is formed to be concave in a direction away from the display module.

3. The electronic device of claim 2, wherein the contact hole is formed of a material different from the RF connection member and is disposed in at least one groove portion and connected to the RF connection member.

4. The electronic device of claim 3, wherein the RF connection member is formed of a flexible material and the contact hole is formed of a rigid material.

5. The electronic device of claim 1, further comprising a connection portion, one end of which is connected to the RF connection member and extends adjacent to a rear plate disposed on the rear surface of the electronic device, and the other end of which is connected to the printed circuit board and the RF connection member is connected to the printed circuit board.

6. The electronic device of claim 1, wherein the frame comprises a first frame and a second frame which are electrically separated, and the contact hole comprises a first contact hole in contact with the first frame and a second contact hole in contact with the second frame.

7. The electronic device of claim 6, further comprising a switching circuit that selectively connects at least one of the first contact hole and the second contact hole, and a communication module of the printed circuit board, and is disposed on the RF connection member.

8. The electronic device of claim 1, further comprising:
a metal plate of a conductive material disposed inside the frame;
a third contact hole connected to the RF connection member and in contact with the metal plate; and
a second bolt member coupled to the metal plate through the third contact hole.

9. The electronic device of claim 1, further comprising an additional antenna connected to the RF connection member, disposed in the frame, and formed of a conductive material.

10. The electronic device of claim 2, wherein the groove portion comprises a first groove portion and a second groove portion formed at different locations, and the contact hole comprises a first contact hole, a second contact hole disposed in the first groove portion, and a third contact hole disposed in the second groove portion.

11. An RF member comprising:
an RF connection member formed by extending in one direction;
at least one groove portion that starts from the first surface of the RF connection member and is formed to be concave to the second surface of the RF connection member opposite to the first surface; and
contact holes which are disposed along the one direction and electrically connected to the RF connection member, and at least one of which is disposed in the groove portion.

12. The RF member of claim 11, wherein the RF connection member is formed of a flexible material, and the contact hole is formed of a rigid material.

13. The RF member of claim 11, wherein the groove portion comprises a first groove portion and a second groove portion formed at different locations, and the contact hole comprises a first contact hole, a second contact hole disposed in the first groove portion, and a third contact hole disposed in the second groove portion.

14. The RF member of claim 11, further comprising a connection portion that is connected to a portion adjacent to the first surface of the RF connection member and extends in a direction away from the second surface of the RF connection member.

15. The RF member of claim 11, further comprising an additional antenna connected to the RF connection member and formed of a conductive material.
